# EUROPEAN PATENT SPECIFICATION

(11) **EP 3 782 287 B1**
(45) Date of publication and mention of the grant of the patent: **29.06.2022**
(21) Application number: 18728247.0
(22) Date of filing: 16.04.2018
(51) Int. Cl.: H03K 17/975

(54) **CAPACITIVE CONTROL SYSTEM, IN PARTICULAR A STEERING WHEEL COLUMN INTEGRATED MODULE OF AN AUTOMOTIVE VEHICLE**
KAPAZITIVES STEUERUNGSSYSTEM, INSBESONDERE EIN IN DIE LENKRADSÄULE INTEGRIERTES MODUL EINES KRAFTFAHRZEUGES
SYSTÈME DE COMMANDE CAPACITIF, EN PARTICULIER MODULE INTÉGRÉ DE COLONNE DE DIRECTION D'UN VÉHICULE AUTOMOBILE

(43) Date of publication of application: 24.02.2021
(73) Proprietor: MERIT AUTOMOTIVE ELECTRONICS SYSTEMS S.L.U, 08620 - Barcelona (ES)
(72) Inventor: WOZNIAK, Marek, 30-552 Kraków (PL); SYREK, Wojciech, 34-113 Sosnowice (PL)
(74) Representative: Lukaszyk, Szymon
(86) International application number: PCT/PL2018/000037
(87) International publication number: WO 2019/203668

(56) References cited:
- WO-A1-2016/184728
- GB-A- 1 584 345
- US-A1- 2014 021 024

## Description

The present invention relates to a capacitive control system, in particular a steering wheel column integrated module of an automotive vehicle, comprising a support, at least one control element disposed displaceably within the support, at least one first capacitive activating region adjacent to a second capacitive activating region and disposed beneath and cooperating with said control element to change the distance and thus electrical capacitance between the first and the second capacitive activating regions.

### Background of the Invention

Capacitive control systems of this kind are known to be used as computer keyboards or push-buttons. Contactless capacitive keyboards and push-buttons, which are therefore more resistant to wear and oxidation have also been proposed in the prior art.

Patent application US2017111044 for example discloses a capacitive sensitive key structure including a key, a support component, a fixing pad, a substrate and a conductive portion. The key includes a key body and a connection wall which encloses a receiving space. The support component is disposed in the receiving space and includes a body, conical wall, buffering space, and extending pad connected to the conical wall. The body abuts against the key body. The conductive portion is disposed at the bottom of the body and inside the buffering space. The substrate is connected to the fixing pad and has thereon a circuit unit and a sensing layer. The substrate is coated with an insulating layer which covers the sensing layer. When the key body is pressed to press against the support component, electrostatic changes occur because of changes in the distance between the conductive portion made of conductive silicone and the sensing layer of the substrate; hence the key body drives the circuit unit to generate an electrical signal when the distance changes to a predetermined distance (less than 0.5 mm) without coming into direct contact with the substrate.

Similar contactless electric signal devices of a capacitive nature are disclosed in the specifications US3653038, US1665616 and FR2431223.

Patent publication GB 1 584 345 A discloses a keyboard having a plurality of key stations and comprising a printed circuit board having a plurality of capacitor plates formed thereon, each key station including a key and means arranged to support the key for operative movement and wherein conductive metal spring means are provided having a plurality of separately movable portions of an integral spring strip, the separately movable portions bearing resiliently against the lower ends of respective keys for separately urging the various keys upwardly, said separately movable portions constituting electrically connected but separately movable key-operated capacitor plates, co-operating respectively with fixed capacitor plates on the printed circuit board.

It is often desirable to provide a haptic response to user touching the control element, so he or she would know that a desired predefined effect has indeed been effected without any other response of the system.

This need is particularly visible if the control system is to be used by a driver in a cockpit of a vehicle and in particularly if the control system has a form of a steering wheel column integrated module. Haptic response provides the driver with an immediate somatosensory reaction, which is neither visually nor auditory distracting.

Steering wheel column integrated modules in an automotive industry are usually used for controlling various components and subsystems of a vehicle including lights, windscreen wipers, washer, cruise control, audio system, etc. They usually form compact, preassembled units that at the vehicle assembly line are mechanically fixed to the vehicle dashboard or steering wheel column and are electrically connected to the vehicle wiring. Commonly the control functionality of the column integrated modules is implemented using force-sensing, resistive foils or conductive contact switches, while the haptic functionality is implemented using springs or spring plungers. Unfortunately these solutions are relatively expensive and inaccurate, while their assembly is complicated.

Therefore it has been the object of the present invention to provide a robust capacitive control system, which would be devoid of the drawbacks of the prior art solutions, cost efficient and simple to manufacture and assembly.

### Summary of the Invention

The invention provides a capacitive control system of the kind mentioned in the outset, as recited in the independent Claim 1.

The term "control element" as used herein denotes an element which is rotated or otherwise similarly displaced by user in order to effect a predefined effect in the module controlled by the control system.

The control system of the present invention works in a contactless, capacitive mode, thus no short circuits, oxidation and burnouts take place between the capacitive activating regions.

Preferably the system comprises a number of rotational control elements.

The system comprises at least one shaped uniform piece provided with a number of said arms, wherein each control element is haptically engaged with at least one arm. The system may obviously comprise just one shaped uniform piece provided with all the first capacitive activating regions, or two shaped pieces arranged symmetrically.

Preferably at least one control element is haptically engaged with more than one arm. This provides different activation modes for the control element.

Said at least one rotational control element is provided with internal recesses or projections in a form of an internal cam.

Preferably the system is provided with a printed circuit board disposed beneath said deformable arm and said at least one second capacitive activating region has a form of a conductive trace of said printed circuit board.

A printed circuit board with the second capacitive activating regions is therefore disposed perpendicularly to the plane of displacement of the arms and therefore the system may comprise just one printed circuit board provided with all the second capacitive activating regions, preferably on both sides thereof. This obviously reduces complexity and costs of the system.

Preferably said support is provided with at least one bearing for said at least one rotational control element.

Preferably said at least one rotational control element is a multi-stable control element or a mono-stable control element.

The control system of the present invention comprises a small amount of distinct parts, which makes it compact and simple to manufacture and assembly.

### Brief description of drawings

The invention shall be described and explained below in connection with the attached drawings in which:
Fig. 1 is a schematic perspective, exploded view of an embodiment of a capacitive control system according to the present invention;
Fig. 2 is a schematic cross-sectional view of the assembled system of Fig. 1;
Fig. 3 is a schematic perspective view of a shaped element containing all first capacitive activating regions of the system of Fig. 1;
Fig. 4 is a schematic perspective view of a first rotational control element of the system of Fig. 1;
Fig. 5 schematically illustrates four different exemplary activation modes of the first rotational control element shown in Fig. 4
Fig. 6 is a schematic cross-sectional view of the system of Fig. 1 along the plane A-A of Fig. 2;
Fig. 7 is a schematic perspective view of a second rotational control element of the system of Fig. 1;
Fig. 8 is a schematic cross-sectional view of the system of Fig. 1 along the plane B-B of Fig. 2;
Fig. 9 is a schematic cross-sectional view of the system of Fig. 1 in the area of a slidable control element; and
Fig. 10 is a schematic perspective view of an internal bearing element of the system of Fig. 1.

### Detailed description of preferred embodiment

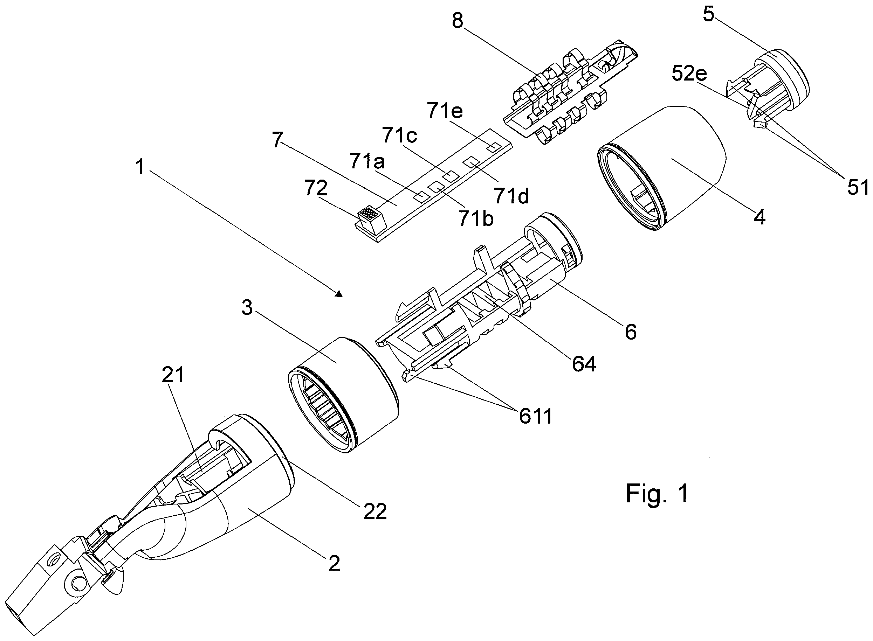

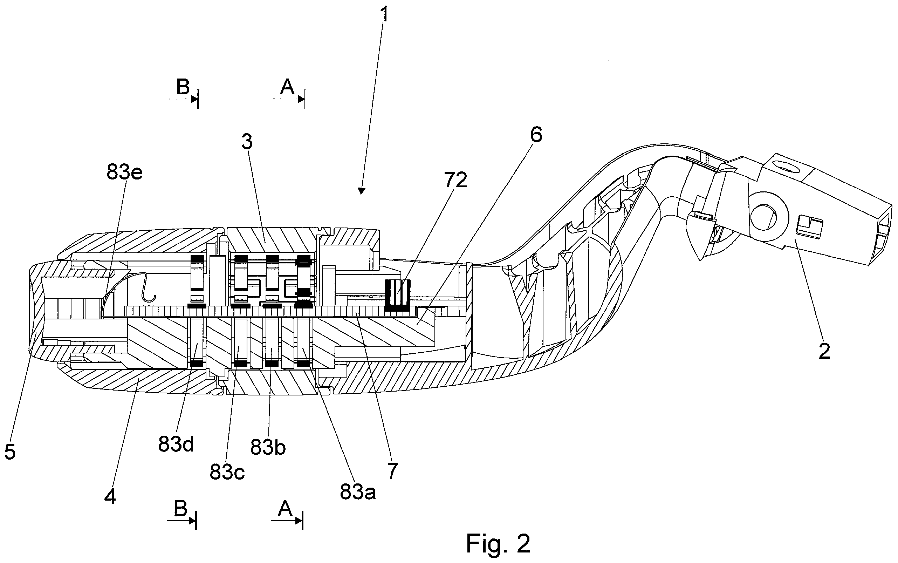

The embodiment of a capacitive control system 1 shown in Fig. 1 and Fig. 2 has a form of an automotive control system, and more particular a steering wheel column integrated module (CIM). The system 1 comprises a control lever 2, controlled inclinations of which may be used for example for turning the vehicle windscreen wipers or cruise control on and off, etc., a multi-stable first rotational control element 3, the rotations of which may be used for example for controlling wipers frequency, cruise control speed, etc., a mono-stable second rotational control element 4, the rotations of which may be used for example for controlling rear windscreen washer, and a mono-stable slidable (push) control element 5, the axial displacement of which may be used for example for controlling front windscreen washer, cruise control memory, etc.

All the control elements 3, 4 and 5 of the system 1 along with the control lever 2 form a preassembled unit that at the vehicle assembly line shall be mechanically fixed to the vehicle steering wheel column, not shown in the drawing, and electrically connected to the vehicle wiring in a manner well known to those skilled in the art.

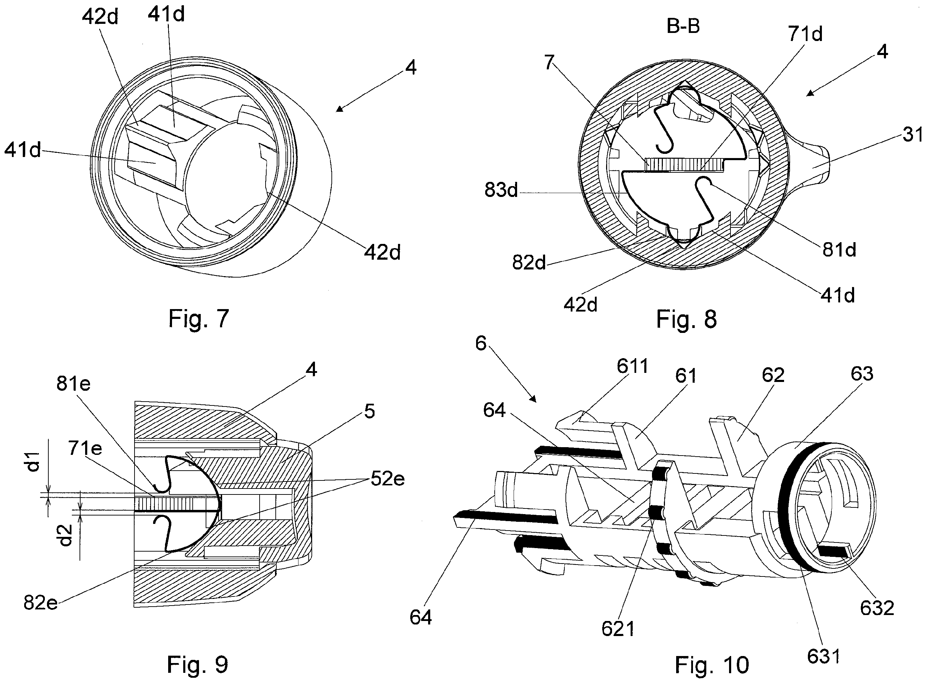

In this embodiment the control system 1 comprises a support in a form of an internal bearing element 6 that provide fixing and guidance for the control elements 3, 4 and 5. The element 6 is provided with three cylindrical parts 61, 62 and 63 which are positioned perpendicularly to the axis of the element 6 (cf. Fig. 10).

The internal bearing element 6 is snap-locked within the lever 2 by means of four axial snap-locking protrusions 611 of the first cylindrical part 61 and cooperating with four snap-locking recessions 21 in the lever 2. The rotational control elements 3 and 4 are disposed rotationally in sequence over the internal bearing element 6, and the slidable control element 5 is slidably snap-locked within the internal bearing element 6 and inside the second rotational control element 4 with its four snap-locking protrusions 51 slidably engaging the third cylindrical part 63 of the element 6. Other forms of fixing and guidance of the control elements 3, 4 and 5 shall obviously be well known to those skilled in the art.

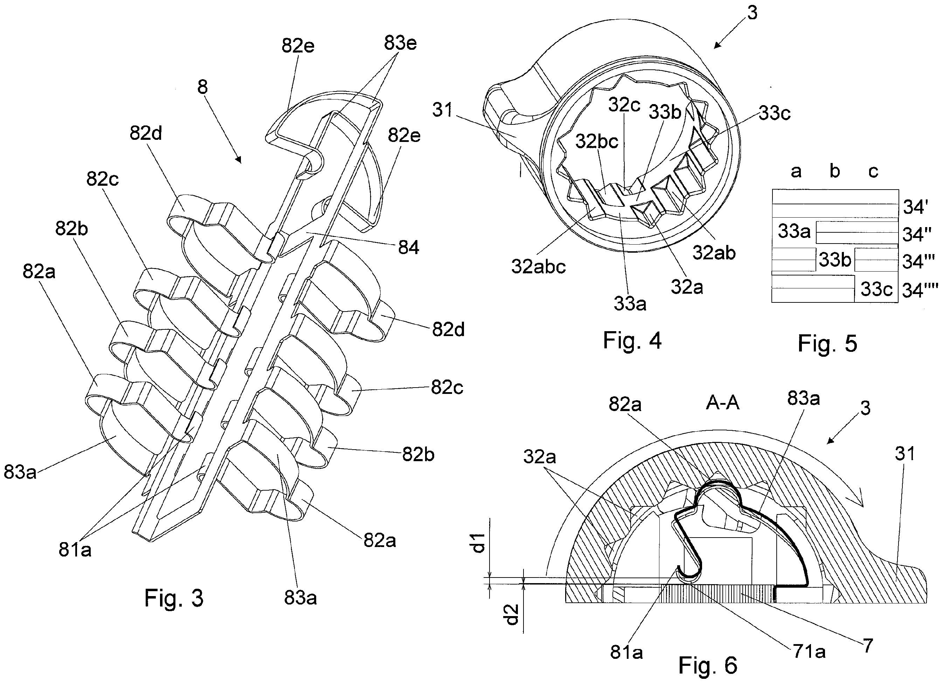

A printed circuit board 7 is fixed within a socket 64 the internal bearing element 6 and comprises a plug 72 enabling for electrical connection of the control system to the vehicle wiring. A shaped metal piece 8 (cf. Fig. 3) is disposed between the internal bearing element 6 and the control elements 3, 4 and 5. The piece 8 is electrically connected with the printed circuit board 7 through its conducting plate 84 soldered to the conductive trace of the printed circuit board 7 (not shown).

As shown in detail in Fig. 3 the piece 8 comprises five pairs of deformable arms 83a-83e cooperating with the control elements 3, 4 and 5 as shall be described later. Each pair of arms 83* is arranged symmetrically with respect to the plane of the printed circuit board 7. Each of arms 83a-83e is provided at its end with a first capacitive activating region 81a-81e. The printed circuit board 7 on the other hand (cf. Fig. 1) comprises five pairs of second capacitive activating regions 71a-71e in the form of conductive traces disposed on the opposite faces of the board 7. Each second capacitive activating region 71a-71e of the printed circuit board 7 is disposed beneath the corresponding first capacitive activating region 81a-81e of the shaped metal piece 8.

Such a symmetrical configuration equalises mechanical tensions and bending moments acting on the control elements 3, 4 and 5. To this end the system may obviously comprise two or more pieces 8 preferably symmetrical with respect to plane of the printed circuit board 7.

The arms 83a-83e provide haptical engagement for the control elements 3, 4 and 5. To this end each arm 83a-83d comprises a shaped projection 82a-82d. Shaped projections 82a-82c cooperate with radial recesses 32a-32c of the first rotational control element 3, while shaped projections 82d cooperate with radial recesses 42d of the second rotational control element 4, as shall be explained later. Radial recesses 32a-32c and 42d have forms of internal cams of the control elements 3 and 4.

Displacements of the control elements 3, 4 and 5 result in changes of the distances and thus electrical capacitances between the first 81a-81e and the second 71a-71e capacitive activating regions, independently on the capacitance of the human body.

As shown in Fig. 4 and Fig. 6 the first rotational control element 3 is provided with a radial knob 31 enabling user to sense actually set radial position of the element 3. Radial recesses 32 are disposed axially along the internal surface of the control element 3 (as indicated by the suffixes a, b, c increasing toward the slidable control element 5) with radial flat (not recessed) spacers 33 separating particular radial recesses 32, where appropriate.

As shown in Fig. 4 the axially internal spacer 33a adjoins the recess 32bc, the axially intermediate spacer 33b separates recesses 32a from 32c, while the axially external spacer 33c adjoins the recesses 32ab. Such a configuration enables for different multi-stable activation modes dependent on the radial position of the element 3. Moreover such a cam geometry of the internal surface of the control element 3 promotes stable activation modes (with shaped projections 82 within the recesses 32) rejecting intermediate positions.

Four different exemplary activation modes in a form of 2D section of the inner surface of the control element 3 showing appropriate recesses (32 abc, 32bc, 32a/32c and 32ab) are shown in Fig. 5 corresponding to a-off, b-off, c-off (34'), a-on, b-off, c-off (34"), a-off, b-on, c-off (34"'), a- off, b- off, c-on (34""). These binary codes may be obviously easily mapped in to base-ten numbers as known to those skilled in the art.

As show in Fig. 6 in an *-off position the shaped projections 82 of the arm 83 is located within the radial recess 32, so that the distance d1 between the first capacitive activating region 81 of the arm 83 and the second capacitive activating region 71 of the printed circuit board 7 is larger than the distance d2 corresponding to an *-on position where the shaped projections 82 of the arm 83 abuts the flat spacer 33. This capacitance differences may be measured and accordingly interpreted by the external vehicle control system. In this embodiment the distance d1 amounts about 1.5 mm, while the distance d2 amounts about 0.5 mm.

As shown in Fig. 7 and Fig. 8 the second rotational control element 4 is provided with two radial recesses 42d adjoining radial cams 41d and cooperating with the shaped projection 82d of the arm 83d of the shaped metal piece 8. As show in Fig. 8 in an *⁻off position the shaped projection 82d of the arm 83d is located within the radial recess 42d, so that the distance d1 between the first capacitive activating region 81d of the arm 83d and the second capacitive activating region 71d of the printed circuit board 7 is larger than the distance d2 corresponding to an *-on position where the shaped projection 82d of the arm 83 abuts either of the radial cams 41d. This capacitance differences may also be measured and accordingly interpreted.

As shown in Fig. 9 the slidable or push control element 5 is provided with two recessed faces 52e slanted with respect to the axis of its displacement which abut the shaped projections 82e of the arms 83e. Pushing the element 5 against the tension of the arms 83e decreases the distance between the first (81e) and the second (71e) capacitive activating region triggering activation of a module connected with the control element 5 (not shown). The change of capacitance due to some preliminary push of the control element 5 (or turn as in the case of the control element 4) may also be easily detected. The slidable or push control element 5 is not the subject of the present invention.

As shown in Fig. 10 the bearing element 6 provides bearing and guidance for the control elements 3, 4 and 5. Control element 3 is guided on bearing 22 on an external surface of the lever 2 (cf. Fig. 1) and bearing 621 on the second cylindrical part 62 of the bearing element 6. Control element 4 is guided on bearing 621 and bearing 631 on an external surface of the third cylindrical part 63 of the bearing element 6. Control element 5 is guided on bearing 632 on an internal surface of the third cylindrical part 63 of the element 6. All these bearings substantially reduce undesired radial movement of the movable control elements 3,4 and 5 commonly called "free play" and allow for increased dimensional tolerances.

The above embodiments of the present invention are merely exemplary. The figures are not necessarily to scale and some features may be exaggerated or minimized. These and other factors however should not be considered as limiting the invention, the intended scope of protection of which is indicated in appended claims. List of reference numerals
- 1.: capacitive control system
- 2.: lever
21. snap-locking recessions
22. bearing
- 3.: first (multi-stable) rotational control element
31. radial knob
32. radial recess
33. radial flat spacer
34. activation mode (34a-34d)
- 4.: second (mono-stable) rotational control element
41. radial cam
42. radial recess
- 5.: slidable (mono-stable; push) control element
51. snap-locking protrusions
52. recessed face
- 6.: support (internal bearing element)
61. first cylindrical part 611. snap-locking protrusions
62. second cylindrical part
621. bearing (for elements 3, 4)
63. third cylindrical part
631. bearing (for element 4)
632. bearing (for element 5)
64 printed circuit board socket
- 7.: printed circuit board
72. plug
- 8.: shaped (metal) piece
81. first capacitive activating region (81a'-81e'; 81a"-81e")
82. shaped projection (82a'-82d'; 82a"-82d");
83. arm (83a'-83e'; 83a"-83e")
84. conducting plate

## Claims

1. A capacitive control system (1), in particular a steering wheel column integrated module of an automotive vehicle, comprising a support (6), at least one rotational control element (3, 4) disposed displaceably for a user, wherein the support (6) provides guidance for said at least one rotational control element (3, 4), wherein at least one shaped metal piece (8) is disposed between the support (6) and said at least one rotational control element (3, 4), wherein said piece (8) comprises a plurality of metal, deformable arms (83a-83d) along a first direction of said piece (8) and cooperating with said at least one rotational control element (3, 4), wherein each of the arms (83a-83d) is provided with a first capacitive activating region (81a-81d) adjacent to and facing a second capacitive activating region (71a-71d) and disposed beneath and cooperating with said control element (3, 4), wherein a displacement of said at least one rotational control element (3, 4) results in a change of the distance and thus electrical capacitance between the first (81a-81d) and the second (71a-71d) capacitive activating regions,
wherein said metal, deformable arms (83a-83d) are haptically engaged with said at least one rotational control element (3, 4),
wherein said haptical engagement is provided by a shaped projection (82a-82d) or recess of the arm (83) cooperating with at least one internal recess (32, 42) or projection of said at least one rotational control element (3, 4),
wherein in a first position said shaped projection (82a-82d) or recess of said arm (83) is located within said internal recess (32, 42) or projection of said at least one rotational control element (3, 4), so that a distance (d1) between the first capacitive activating region (81) of said arm (83) and the second capacitive activating region (71) is larger than a distance (d2) corresponding to a position where said shaped projection (82a-82d) or recess of said arm (83) is outside of said internal recess (32, 42) or projection of said at least one rotational control element (3, 4),
and wherein the distance between the first (81a-81d) and the second (71a-71d) capacitive activating regions remains greater than zero.

2. The control system according to Claim 1, **characterized in that** it comprises a number of rotational control elements (3, 4).

3. The control system according to Claim 1 or 2, **characterized in that** at least one control element (3) is haptically engaged with more than one arm (83).

4. The control system according to any one of preceding Claims, **characterized in that** it is further provided with a printed circuit board (7) disposed beneath said deformable arm (83) and said at least one second capacitive activating region (71a-71e) has a form of a conductive trace of said printed circuit board (7).

5. The control system according to any one of preceding Claims, **characterized in that** said support (6) is provided with at least one bearing (611, 621, 631, 632) for said at least one rotational control element (3, 4).

6. The control system according to any one of preceding Claims, **characterized in that** said at least one rotational control element is a multi-stable control element (3) or a mono-stable control element (4).

## Patentansprüche

1. Ein kapazitives Steuersystem (1), insbesondere ein integriertes Lenkradsäulenmodul eines Kraftfahrzeugs, mit einem Träger (6), mindestens einem für einen Benutzer verschiebbar angeordneten Drehsteuerelement (3, 4), wobei der Träger (6) eine Führung für das mindestens eine Drehsteuerelement (3, 4) bietet, wobei mindestens ein geformtes Metallstück (8) zwischen dem Träger (6) und dem mindestens einen Drehsteuerelement (3, 4) angeordnet ist, wobei das Stück (8) eine Vielzahl von verformbaren Metallarmen (83a-83d) entlang einer ersten Richtung des Stücks (8) umfasst und mit dem mindestens einen Drehsteuerelement (3, 4) zusammenwirkt, wobei jeder der Arme (83a-83d) mit einem ersten kapazitiven Aktivierungsbereich (81a-81d) versehen ist, der an einen zweiten kapazitiven Aktivierungsbereich (71a-71d) angrenzt und diesem gegenüberliegt und unterhalb des Steuerelements (3, 4) angeordnet ist und mit diesem zusammenwirkt, wobei eine Verschiebung des mindestens einen Drehsteuerelements (3, 4) zu einer Änderung des Abstands und somit der elektrischen Kapazität zwischen dem ersten (81a-81d) und dem zweiten (71a-71d) kapazitiven Aktivierungsbereich führt,
wobei die verformbaren Metallarme (83a-83d) haptisch mit dem mindestens einen Drehsteuerelement (3, 4) in Eingriff stehen,
wobei der haptische Eingriff durch einen geformten Vorsprung (82a-82d) oder eine Aussparung des Arms (83) bereitgestellt wird, der/die mit mindestens einer inneren Aussparung (32, 42) oder einem Vorsprung des mindestens einen Drehsteuerelements (3, 4) zusammenwirkt,
wobei in einer ersten Position der geformte Vorsprung (82a-82d) oder die Aussparung des Arms (83) innerhalb der inneren Aussparung (32, 42) oder des Vorsprungs des mindestens einen Drehsteuerelements (3, 4) angeordnet ist, so dass ein Abstand (d1) zwischen dem ersten kapazitiven Aktivierungsbereich (81) des Arms (83) und dem zweiten kapazitiven Aktivierungsbereich (71) größer ist als ein Abstand (d2), der einer Position entspricht, in der sich der geformte Vorsprung (82a-82d) oder die Aussparung des Arms (83) außerhalb der inneren Aussparung (32, 42) oder des Vorsprungs des mindestens einen Drehsteuerelements (3, 4) befindet,
und wobei der Abstand zwischen dem ersten (81a-81d) und dem zweiten (71a-71d) kapazitiven Aktivierungsbereich größer als Null bleibt.

2. Das Steuersystem nach Anspruch 1, **dadurch gekennzeichnet, dass** es eine Anzahl von Drehsteuerelementen (3, 4) umfasst.

3. Das Steuersystem nach Anspruch 1 oder 2, **dadurch gekennzeichnet, dass** mindestens ein Steuerelement (3) mit mehr als einem Arm (83) haptisch in Eingriff steht.

4. Das Steuersystem nach einem der vorhergehenden Ansprüche, **dadurch gekennzeichnet, dass** es außerdem mit einer gedruckten Leiterplatte (7) versehen ist, die unter dem verformbaren Arm (83) angeordnet ist, und dass der mindestens eine zweite kapazitive Aktivierungsbereich (71a-71e) die Form einer Leiterbahn der gedruckten Leiterplatte (7) hat.

5. Das Steuersystem nach einem der vorhergehenden Ansprüche, **dadurch gekennzeichnet, dass** der Träger (6) mit mindestens einem Lager (611, 621, 631, 632) für das mindestens eine Drehsteuerelement (3, 4) vorgesehen ist.

6. Das Steuersystem nach einem der vorhergehenden Ansprüche, **dadurch gekennzeichnet, dass** das mindestens eine Drehsteuerelement ein multistabiles Steuerelement (3) oder ein monostabiles Steuerelement (4) ist.

## Revendications

1. Un système de commande capacitif (1), en particulier un module intégré de volant de la colonne de direction d'un véhicule automobile, comprenant un support (6), au moins un élément de commande de rotation (3, 4) disposé de façon amovible pour un utilisateur, dans lequel le support (6) fournit un guidage pour ledit au moins un élément de commande de rotation (3, 4), dans lequel au moins une pièce métallique façonnée (8) est disposée entre le support (6) et ledit au moins un élément de commande de rotation (3, 4), dans lequel ladite pièce (8) comprend une pluralité de bras métalliques déformables (83a-83d) le long d'une première direction de ladite pièce (8) et coopérant avec ledit au moins un élément de commande de rotation (3, 4), dans lequel chacun des bras (83a-83d) est muni d'une première région d'activation capacitive (81a-81d) adjacente à et faisant face à une seconde région d'activation capacitive (71a-71d) et disposée sous et coopérant avec ledit élément de commande (3, 4), dans lequel un déplacement dudit au moins un élément de commande de rotation (3, 4) entraîne un changement de la distance et donc de la capacité électrique entre les première (81a-81d) et seconde (71a-71d)régions d'activation capacitives,
dans lequel lesdits bras métalliques déformables (83a-83d) sont engagés de façon haptique avec ledit au moins un élément de commande de rotation (3, 4),
dans lequel ledit engagement haptique est fourni par une projection en forme (82a-82d) ou un évidement du bras (83) coopérant avec au moins un évidement interne (32, 42) ou une projection interne dudit au moins un élément de commande de rotation (3, 4),
dans lequel, dans une première position, ladite projection en forme (82a-82d) ou ledit évidement dudit bras (83) sont situés à l'intérieur dudit évidement interne (32, 42) ou de ladite projection dudit au moins un élément de commande de rotation (3, 4), de sorte qu'une distance (d1) entre la première région d'activation capacitive (81) dudit bras (83) et la seconde région d'activation capacitive (71) est plus grande qu'une distance (d2) correspondant à une position où ladite projection en forme (82a-82d) ou ledit évidement dudit bras (83) est à l'extérieur dudit évidement interne (32, 42) ou de ladite projection dudit au moins un élément de commande de rotation (3, 4),
et dans lequel la distance entre la première (81a-81d) et la seconde (71a-71d) régions d'activation capacitives reste supérieure à zéro.

2. Le système de commande selon la revendication 1, **caractérisé en ce qu'**il comprend un certain nombre d'éléments de commande de rotation (3, 4).

3. Le système de commande selon les revendications 1 ou 2, **caractérisé en ce qu'**au moins un élément de commande (3) est engagé de façon haptique avec plus d'un bras (83).

4. Le système de commande selon l'une quelconque des revendications précédentes, **caractérisé en ce qu'**il est en outre pourvu d'une carte de circuit imprimé (7) disposée sous ledit bras déformable (83) et **en ce que** ladite au moins une seconde région d'activation capacitive (71a-71e) a la forme d'une trace conductrice de ladite carte de circuit imprimé (7).

5. Le système de commande selon l'une quelconque des revendications précédentes, **caractérisé en ce que** ledit support (6) est muni d'au moins un palier (611, 621, 631, 632) pour ledit au moins un élément de commande de rotation (3, 4).

6. Le système de commande selon l'une quelconque des revendications précédentes, **caractérisé en ce que** ledit au moins un élément de commande de rotation est un élément de commande multi-stable (3) ou un élément de commande mono-stable (4).
